(19) Europäisches Patentamt
European Patent Office
Office européen des brevets

(11) EP 1 151 309 B1

(12) EUROPEAN PATENT SPECIFICATION

(45) Date of publication and mention
of the grant of the patent:
**02.05.2003 Bulletin 2003/18**

(51) Int Cl.⁷: **G01R 15/24**, G02B 6/27

(21) Application number: **00913423.0**

(86) International application number:
**PCT/US00/03469**

(22) Date of filing: **10.02.2000**

(87) International publication number:
**WO 00/048008 (17.08.2000 Gazette 2000/33)**

(54) **POLARIZATION TRANSFORMER AND CURRENT SENSOR USING THE SAME**

POLARISATIONSWANDLER UND STROMSENSOR UNTER VERWENDUNG DES SELBEN

TRANSFORMATEUR DE POLARISATION ET CAPTEUR DE COURANT UTILISANT CELUI-CI

(84) Designated Contracting States:
**AT BE CH CY DE DK ES FI FR GB GR IE IT LI LU MC NL PT SE**
Designated Extension States:
**AL LT LV MK RO SI**

(30) Priority: **11.02.1999 US 119999 P**
**11.02.1999 US 120000 P**
**10.05.1999 US 133357 P**
**14.05.1999 US 134154 P**
**22.06.1999 US 337223**
**22.06.1999 US 337231**

(43) Date of publication of application:
**07.11.2001 Bulletin 2001/45**

(73) Proprietor: **KVH Industries, Inc.**
**Middletown, RI 02840 (US)**

(72) Inventor: **DYOTT, Richard, B.**
**Oak Lawn, IL 60463 (US)**

(74) Representative: **Mercer, Christopher Paul et al**
**Carpmaels & Ransford**
**43, Bloomsbury Square**
**London WC1A 2RA (GB)**

(56) References cited:
**WO-A-98/58268        FR-A- 2 535 463**
**US-A- 4 603 941        US-A- 5 701 376**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

**Description**

Background of The Invention

1. Field of the Invention

This application relates to optical devices that transform light between linearly and elliptically polarized light states and their use in current sensors.

2. Description of Related Art

Devices that transform linearly polarized light to circularly polarized light and the reverse are known in the literature. To make such optical devices, one may use one birefringent fiber with two beams of light of equal frequency and amplitude (or, equivalently, one beam that is the vector sum of these two beams). If the two beams are propagated perpendicular to the optic axis, circularly polarized light may result. Alternatively, linearly polarized light may be transformed to circularly polarized light by using one beam and two fibers.

In practice, constructing a single-beam transformer of linearly to circularly polarized light involves first starting with a length of transforming fiber greater than a predetermined length, and performing several iterations of cutting and measuring polarization until the polarization is deemed to be circular to within some specification. Needless to say, this is a tedious and lengthy procedure requiring lots of guesswork.

A transformer of polarized light according to the preamble of claim 1 is disclosed in US-A-4 603 941.

Summary Of The Invention

The invention is defined in claims 1, 2, 4 and 5. An embodiment is defined in claim 3.

A transformer of polarized light is disclosed which has a birefringent fiber that is twisted through an angle into a corkscrew shape at an appropriate distance from an end of the fiber; the angle and distance are so chosen that linearly polarized light entering an end of the fiber farthest from the corkscrew shape exits the fiber elliptically polarized. In various embodiments, the angle is approximately $\pi/4$ radians, and the distance is approximately one quarter of a beat length. The transformer of polarized light may include an optical fiber twisted about a central axis running therethrough wherein the fiber is characterized by the absence of spliced sections.

Also disclosed is a current sensor which includes a source of linearly polarized light, wherein the source of linearly polarized light can include the aforedescribed transformer of polarized light which transforms the linearly polarized light into circularly polarized light; a coil of optical fiber having at least one turn; a directional coupler for optically coupling the circularly polarized light from the transformer of polarized light to the coil to create counter-propagating light beams within the coil; and an optical detector for receiving the counter-propagated light beams for producing an output signal indicative of a magnetic field produced by an electric current. The source of linearly polarized light may be a diode laser.

A method of fabricating a transformer of polarized light is also disclosed which includes twisting a birefringent fiber through an angle, which may be approximately $\pi/4$ radians, to produce a corkscrew shape; and twisting the fiber at a distance of approximately one quarter of a beat length from an end of the fiber. The method may also include heating a birefringent fiber which has a core and a cladding, so as to cause the core and the cladding to interdiffuse, and thereby changing the state of polarization of light that may exit the fiber.

The twisting of the fiber may be fine-tuned by heating the fiber and monitoring the substantially circularly polarized light exiting the fiber. The fiber can be heated before, during, or after the twisting. The angle and distance may be chosen so that polarized light entering the first end exits the second end randomly polarized. The appropriate length may be greater than a decoherence length. For example, substantially polarized light may enter through the first end of the fiber while substantially randomly polarized light exits the second end of the fiber.

A method of detecting an electric current in a conductor is also disclosed which includes providing a source of linearly polarized light; transforming the linearly polarized light into circularly polarized light using a transformer of polarized light as described above; providing a coil of optical fiber having at least one turn; with a directional coupler, coupling the circularly polarized light from the transformer of polarized light to the coil to create counter-propagating light beams within the coil; and receiving the counter-propagated light beams with an optical detector for producing an output signal responsive to a magnetic field produced by the electric current.

Brief Description Of Drawings

Figure 1 illustrates the conventional method of fabricating a transformer of linearly to circularly polarized light by splicing two fibers that are properly oriented.

Figure 2 is a schematic of a twisted fiber of the present invention that obviates the need to splice fibers together.

Figure 3 illustrates how fine tuning of the polarization can be achieved by heating the fiber to cause diffusion of the core into the cladding.

Figure 4 illustrates a current sensor that includes a polarization transformer.

Detailed Description of Certain Embodiments

It is often desirable to transform the polarization of a beam of light from one state to another. For this purpose optical devices have been fabricated that input linearly polarized light and output elliptically polarized light. These devices typically function by causing one of two incident linearly polarized light beams to lag behind the other by a pre-selected phase difference. Altering the relative phase of the two incident beams has the effect of changing the state of polarization of the light that exits the optical device. Before considering how these devices of the prior art perform the transformation of linearly to elliptically polarized light and before presenting the detailed description of the preferred embodiment of the present invention, it will be useful to first recall how elliptically polarized light arises.

Two orthogonal electric fields, $\mathbf{E}_x$ and $\mathbf{E}_y$, both propagating in the z direction can be described by the following two equations

$$E_x = i\, E_{0x} \cos (kz - \omega t) \tag{1}$$

and

$$E_y = j\, E_{0y} \cos (kz - \omega t + \delta), \tag{2}$$

where $\mathbf{i}$ and $\mathbf{j}$ are unit vectors in the x and y directions, k is the propagation number, $\omega$ is the angular frequency, and $\delta$ is the relative phase difference between the two modes. The total electric field $\mathbf{E}$ is just given by the vector sum $\mathbf{E}_x + \mathbf{E}_y$. An observer standing at a fixed point on the z-axis and measuring the components $E_x$ and $E_y$ of the total electric field simultaneously would find that these components would fall on the curve

$$(E_x /E_{0x})^2 + (E_y/E_{0y})^2 - 2\, (E_x /E_{0x})\, (E_y/E_{0y}) \cos \delta = \sin^2 \delta. \tag{3}$$

Equation (3) is the well known equation of an ellipse making an angle $\alpha$ with the $(E_x, E_y)$-coordinate system, where

$$\tan 2\alpha = (2\, E_{0x}\, E_{0y} \cos \delta) \div (E_{0x}^2 - E_{0y}^2). \tag{4}$$

Hence, $\mathbf{E}$ corresponds to elliptically polarized light. From Equation (3) can be seen that the phase difference $\delta$ dictates some of the characteristics of the ellipse. For example, if $\delta$ were equal to an even multiple of $2\pi$ (i.e., if $\mathbf{E}_x$ and $\mathbf{E}_y$ are in phase), then Equation (3) reduces to $E_y = (E_{0y} /E_{0x})\, E_x$, which is the equation of a straight line; in that case, $\mathbf{E}$ is linearly polarized. On the other hand, if $\delta$ is equal to $\pm\pi/2$, $\pm 3\pi/2$, $\pm 5\pi/2,...$, and assuming $E_{0x} = E_{0y} = E_0$, Equation (3) reduces to $E_{0x}^2 + E_{0y}^2 = E_0^2$, which is the equation of a circle. In that case, $\mathbf{E}$ is circularly polarized. Of course, linearly and circularly polarized light are just special cases of elliptically polarized light, a line and a circle being special types of ellipses.

From the above considerations, it is clear that if two perpendicular modes of light with equal amplitudes, such as that described by Equations (1) and (2) with $E_{0x} = E_{0y}$, enter an optical device, and proceed to exit the device with a phase shift of $\pi/2$, the result would be circularly polarized light. Typical optical devices that serve to transform linearly polarized light to circularly polarized light work on this principle.

For example, birefringent light fibers are anisotropic meaning that they do not have the same optical properties in all directions. Such fibers have the following properties: If two linearly polarized light beams are traveling along the fiber, or along the z axis, and furthermore one beam is polarized along the y axis and the other along the x axis, then, while the beam polarized along the y axis will travel at a speed v, the other beam that is polarized along the x axis will have a different speed. In a birefringent fiber, the term "optic axis" may refer to either the fast or the slow axis, which are taken here to be the x and y axes, both perpendicular to the propagation axis, taken here to be the z axis. Such two beams moving perpendicular to the optic axis may enter the fiber in phase, but because of their disparate speeds will exit with a non-zero phase difference $\delta$. The result, as was seen above, is elliptically polarized light.

In the time, $\Delta t$, that it takes the faster moving beam to traverse the birefringent fiber, the faster moving beam, with speed $v_{fast}$, will outpace the slower moving beam, with speed $v_{slow}$, by a distance $(v_{fast}-v_{slow})\Delta t$. This last mentioned distance contains $(v_{fast}-v_{slow})\Delta t / \lambda_{slow}$ waves of the slower moving beam having wavelength $\lambda_{slow}$. Noting that $\Delta t = L / v_{fast}$, where L is the fiber length, the phase difference between the two beams is given by

$$\delta = 2\pi \, (v_{fast}-v_{slow}) \, L / (\lambda_{slow} \, v_{fast}). \qquad (5)$$

This last equation can be rewritten by substituting

$$v_{fast}=\lambda_{fast}v, \qquad (6)$$

and

$$v_{slow}=\lambda_{slow}v, \qquad (7)$$

where v is the common frequency of the slow and fast beams, to yield

$$L = (\delta/2\pi)(1/\lambda_{slow} - I/\lambda_{fast})^{-1} \qquad (8)$$

This last equation makes clear that one can tailor a birefringent fiber to act as a transformer of linearly polarized light into elliptically polarized light simply by choosing the correct length, L, of fiber, although this length depends on the frequency of the light through Equations (7) and (8). The length of fiber that results in a phase difference of $2\pi$ and that therefore leaves the polarization unchanged is known as a beat length, denoted by $L_b$, and will play a role in the discussion below.

To make optical devices that transform linearly polarized light into elliptically polarized light, one may use a birefringent fiber with two beams of light of equal frequency and amplitude (or, equivalently, one beam that is the vector sum of these two beams since, as is known in the art, a single beam of linearly polarised light may be described as the vector sum of two beams, each with a single linear polarization component, conversely, two linearly polarised beams may be vector summed into a single linearly polarised beam). Alternatively, polarization components of unequal amplitude may be employed. As was discussed above, if the two beams are propagated perpendicular to the x axis, and their polarizations are along the x and y axes, elliptically polarized light may result. Alternatively, linearly polarized light may be transformed to circularly polarized light by using one beam and two fibers, one of which is birefringent and of length $L_b/4$.

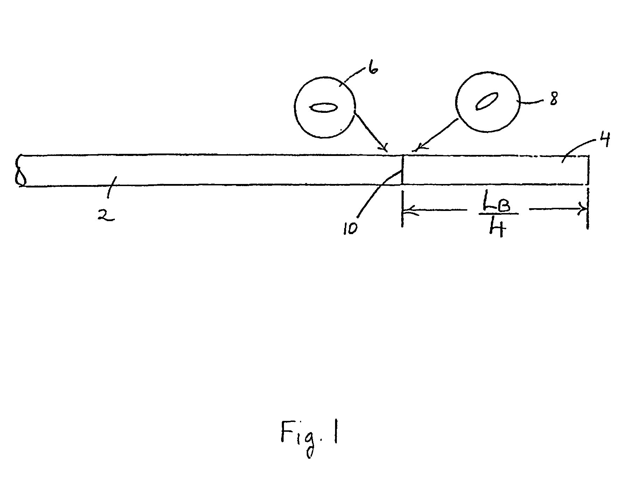

Referring to Figure 1, such a single-beam transformer of linearly polarized light to circularly polarized light may be constructed by fusing two silica or glass fibers. One of these fibers is the transmitting fiber 2 that delivers light to a second birefringent fiber known as the transforming fiber 4. The transforming fiber 4 is cut to a length of $L_b/4$. In addition, the relative orientation of the two fibers is chosen so that the direction of polarization of a light beam traveling in the transmitting fiber 2 is rotated $\pi/4$ radians with respect to the optic axis of the transforming fiber's optic axis, as indicated by the transmitting fiber cross section 6 and the transforming fiber cross section 8. Such an operation may be done with a standard commercially available fusion splicer. However, any misalignment of the fibers results in some light being lost at the splice 10. Moreover, as Equation 5 makes clear, errors in the phase difference $\delta$ grow linearly with errors in the fiber length L. In practice, constructing a single-beam transformer of linearly to circularly polarized light involves first starting with a length of transforming fiber 4 greater than $L_b/4$, and performing several iterations of cutting and measuring polarization until the polarization is deemed to be circular to within some specification. Needless to say, this is a tedious and lengthy procedure requiring lots of guesswork.

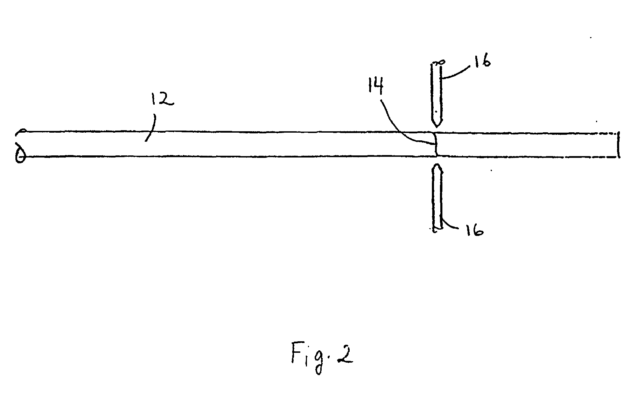

The present invention resolves some of the aforementioned problems by presenting an alternate method of fabricating a single-beam transformer of polarized light. Referring to Figure 2, instead of splicing two fibers offset by $\pi/4$ radians, in the method of the present invention a single birefringent fiber 12 is twisted by this angle. The twist 14 in the fiber can be accomplished by heating the birefringent fiber 12 using arc electrodes 16.

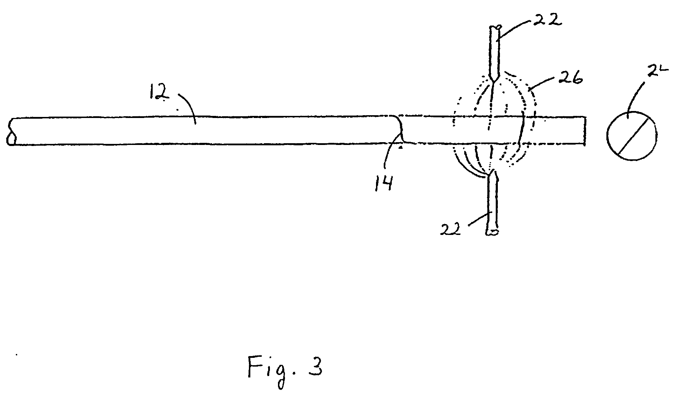

Referring to Figure 3, in lieu of the tedious iterations of cutting and monitoring, in the method of the present invention, fine tuning is achieved by heating with a diffusing arc 26 produced by arc electrodes 22 to cause diffusion of the fiber core into the cladding. The heating can continue until a polarization monitor 24 indicates that the right polarization state is achieved. The effect of the diffusion is to expand the fields of the fiber modes and so reduce the effective difference $v_{fast}-v_{slow}$.

The steps of twisting and diffusing are conceptually independent, and each can be used profitably to make transformers of linearly to elliptically polarized light. Varying the angle through which the birefringent fiber 12 is twisted is tantamount to varying the amplitudes $E_{0x}$ and $E_{0y}$ of Equation (3) and results in different states of elliptically polarized light. The step of diffusing, on the other hand, can be used any time some fine tuning of the polarization is required. For example, after splicing two fibers of appropriate length according to conventional methods, the state of polarization can be fine tuned by causing the core to diffuse into the cladding.

One can also fabricate a transformer using one birefringent fiber and two beams of linearly polarized light. If the two beams are propagated perpendicular to the x (i.e., the optic) axis, and their polarizations are along the x and y axes, elliptically polarized light results. After cutting the single fiber to an appropriate length, fine tuning of the sought-after polarization can be achieved by heating the fiber to cause diffusion of the core into the cladding as mentioned above.

The present invention presents a more convenient method to fabricate a transformer of polarized light. The first step of the method obviates the need to splice a transmitting fiber 2 to a transforming birefringent fiber 4 of length $L_b/4$ with the aim of producing a transformer of linearly to circularly polarized light. Instead, a convenient length of a birefringent fiber 12 is heated to the softening point of the glass and then twisted through an angle of approximately $\pi/4$ radians, the direction of the twist 14 (i.e. clockwise or anticlockwise) determining whether the emitted light is right or left circularly polarized. In a preferred embodiment, the twisting should occur over as short a length as possible. Twisting a single fiber by $\pi/4$ radians instead of splicing two fibers offset by this angle keeps optical losses low. What losses do occur are scarcely measurable in practice.

In the next step of the invention, fine tuning is performed in the following manner. First, the birefringent fiber 12 is cut so that its length from the twist 14 to the end of the fiber is slightly larger than $L_b/4$. The twisted birefringent fiber 12 is positioned between the arc electrodes 22 of a fiber fusion splicer where the arc electrodes 22 are retracted further from the fiber than their position in a normal splicing operation. A diffusing arc 26 is struck at a current lower than that used for splicing in order to raise the temperature of the birefringent fiber 12 to a point below its melting point but where the fiber core begins to diffuse into the cladding. The effect of the diffusion is to expand the fields of the fiber modes and so reduce the effective index of propagation. The light emerging from the transformer is monitored during this operation with the use of a polarization monitor 24, and diffusion is stopped when the light is circularly polarized. Figure 3 shows the arrangement.

Although what was described above is a preferred method for fabricating a single-beam transformer of linearly to circularly polarized light by the steps of twisting and diffusing, it should be understood that these two steps are independent and each may be profitably used individually. For example, to form a single-beam transformer of linearly to circularly polarized light, a single birefringent fiber can be twisted as described above, and then fine tuned not by the preferred method of diffusing, but by a conventional method of iterations of cutting the fiber to an appropriate length and monitoring the polarization.

Alternatively, two fibers may be spliced together as in usual approaches. The transforming fiber would then be cut to a length of approximately $L_b/4$. However, unlike the usual methods that then fine tune by iterations of cutting and monitoring, the tuning could proceed by causing the core to diffuse into the cladding, as described above.

Finally, instead of twisting a birefringent fiber through an angle of $\pi/4$ radians, which corresponds to choosing $E_{0x} = E_{0y}$ in Equation (3), the fiber could be twisted through varying angles. This would be effectively equivalent to varying the amplitudes $E_{0x}$ and $E_{0y}$. As can be seen from this equation, even if the length of the fiber would lead to a phase difference of $\pi/4$ radians, the result would generally be elliptically polarized light that is non-circular.

The above methods have involved fabricating a single-beam transformer of linearly to circularly, or in the case where the twisting angle is not $\pi/4$ radians, elliptically polarized light. As mentioned above, one can also build a transformer using one birefringent fiber and two beams of linearly polarized light (of course, two beams of superposed light is equivalent to a single beam equal to the vector sum of the two constituent beams). If the two beams are propagated along the z axis perpendicular to the x (i.e., the optic) axis, and their polarizations are along the x and y axes, elliptically polarized light may result. According to Equations 3, 4, and 5, the type of elliptically polarized light that results depends on the length of the fiber, L. After cutting a birefringent fiber to an appropriate length, fine tuning of the polarization can proceed by diffusing the core into the cladding, as described above.

The transformer of linearly to circularly polarized light described above can be used in a current sensor exploiting the Faraday Effect in a Sagnac interferometer. A main feature of a Sagnac interferometer is a splitting of a beam of light into two beams. By using mirrors or optical fibers, both beams of light are made to traverse at least one loop, but in opposite directions. At the end of the trip around the loop, both beams are recombined thus allowing interference to occur. Any disturbance that affects one or both beams as they are traversing the loop has the potential to alter the interference pattern observed when the beams recombine. Rotating the device is the traditional disturbance associated with Sagnac's name. Another disturbance, giving rise to the Faraday Effect, involves applying an external magnetic field to the medium that forms the loop through which the light travels. Under the influence of such a field, the properties of the light-transmitting medium forming the loop are altered so as to cause a change in the direction of polarization of the light. In turn, this change in the direction of polarization results in a change in the interference pattern observed. These types of disturbances that give rise to a modification in the observed interference pattern are known as non-reciprocal disturbances. They are so-called because, unlike reciprocal effects in which the change produced in one beam cancels with that produced in the other, the changes produced in the two beams reinforce to yield a modification in the resultant interference pattern.

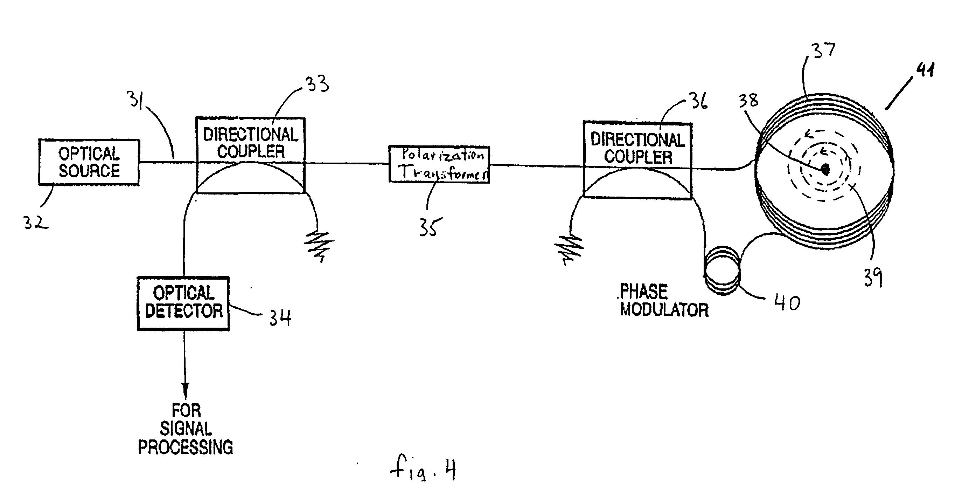

In Figure 4 is shown a schematic of a Sagnac interferometer current sensor of the present invention. The light beam 31 emerges from a laser source 32 which is preferably a diode laser oscillating predominantly in a single transverse mode and having a broad and Gaussian-shaped optical spectrum so that back-scatter noise and Kerr-effect problems are reduced. The light beam 31 passes through a first directional coupler 33 that isolates the optical detector 34, and then a transformer 35 of linearly to circularly polarized light to ensure a single polarization state, which in a preferred embodiment is circular polarization. The light beam is then split in two by the second directional coupler 36. One beam is directed into one end of a sensing coil 41 comprising loops of polarization maintaining fiber 37; this polarization maintaining fiber 37 is not birefringent. The other light beam from the directional coupler 36 is directed through a phase modulator 40 into the other end of the sensing coil comprising loops of polarization maintaining fiber 37. Light emerging from the two fiber ends is recombined by the directional coupler 36 and detected by an optical detector 34.

A current carrying wire 38, with its accompanying magnetic field 39, runs out of the page. The magnetic field 39 changes the physical properties of the sensing coil of polarization maintaining fiber 37. The circular polarization of both beams traveling around the sensing coil of polarization maintaining fiber 37 is thus modified. In particular, the magnetic field causes a phase shift (which should not be confused with the phase difference $\delta$ from Equation (2)) corresponding to a rotation of the direction of the electric field. This phase shift results in a change in the interference when both light beams are reunited at the directional coupler 36 before passing through the transformer 35 of linearly to circularly polarized light to the optical photodetector 34.

As mentioned above, in a preferred embodiment the state of polarization of the light beams entering the sensing coil of polarization maintaining fiber 37, after leaving the transformer 35 of linearly to circularly polarized light, is circular. Correspondingly, the coil's polarization maintaining fiber 37 is circularly cored. However, when the fiber 37 is bent into a coil, stresses occur that give rise to anisotropic effects. For this reason it is advantageous to prepare the fiber 37 for the transmission of light by annealing the fiber 37 while it is in a coil. It is desirable to keep the fiber as symmetrical as possible; in the absence of an external magnetic field, one aims to not change the phase of the transmitted light appreciably over the length of the sensing coil, which is about six meters long. Ideally, the beat length should not be less than six meters; however, in the case at hand, the beat length is approximately 3 millimeters. Thus one should start with a fiber that is as symmetrical as possible. One may draw the fiber from a pre-form as the pre-form is spun around with the goal of producing a symmetrical fiber. As mentioned above, after the fiber is wound into a coil, annealing can help eliminate any stresses.

The transformer 35 of linearly to circularly polarized light is that transformer discussed above wherein a birefringent fiber is twisted through 45 degrees after which it is cut at approximately one quarter of a beat length . Fine tuning may then proceed as described above with one addition: the end closest to the twist is first spliced to the circular cored fiber that is wound into the sensing coil of polarization maintaining fiber 37. Only then does the fine tuning proceed by heating.

In measuring the phase shift $\alpha$ arising from the Faraday Effect, it is helpful to remember that the measured optical power is proportional to the square of the absolute value of the detected electric field. Ignoring the non-reciprocal power difference, which is negligible for the typically used coil lengths, the detected power turns out to be proportional to $(1+\cos \alpha)$. This factor presents somewhat of a difficulty when trying to measure the typically small phase shifts $\alpha$. In particular, the rate of change of $1+\cos \alpha$ is asymptotic to $-\alpha$, as $\alpha$ approaches zero, making it difficult to experimentally measure changes in the phase shift. It therefore becomes necessary to add a biasing phase difference to shift the sensed signal so as to avoid both the maxima and minima of the sinusoid. The phase modulator 40 in Figure 4 performs this function by creating the desired amount of phase difference modulation. Since the phase modulator 40 is positioned at one end of the polarization maintaining fiber 37, the two counter-propagating light beams both receive the same phase modulation but at different times, thereby realizing a non-reciprocal phase difference modulation between the interfering beams. Since the sensed signal becomes biased on a high-frequency carrier, (i.e., the phase modulation signal,) electronic noise is substantially eliminated while measurement sensitivity is increased.

For the current sensor of Figure 4, a unitary length of optical fiber is used for the polarization maintaining fiber 37, with a segment of fiber extending from one end of the coil being used to establish a light path between the optical source 32, the directional coupler 33, the transformer 35 of linearly to circularly polarized light, and the coupler 36. A segment of fiber extending from the other end of the polarization maintaining fiber 37 establishes a light path between the corresponding coil end, the phase modulator 40 and the directional coupler 36.

For optimizing the performance of the current sensor of Figure 4, magnetic field sensitivity must be maximized and noise sensitivity must be minimized. To accomplish this, it is desirable to match the transit time t required for the counter-propagating light beams to traverse the length of the fiber coil with the phase modulation frequency $f_m$ according to the following relationship:

$$\omega_m t = \pi \tag{9}$$

where $\omega_m$ is the radian frequency of the modulation source and is equal to $2\pi f_m$. In terms of the group velocity $v_g$ of the optical wave guided by the fiber, the transit time t is defined as

$$t = L_f/v_g \tag{10}$$

where $L_f$ is the length of the polarization maintaining fiber 37. Substituting Eq. (10) into Eq. (9) yields the following expression for the modulation frequency:

$$f_m = v_g/2L_f. \tag{11}$$

Since the group velocity $v_g$ is approximately equal to c / n, where c is the speed of light in vacuum, and n is the average refractive index of the fiber core and cladding, the quantity $v_g$ represents a constant. Accordingly, the modulation frequency $f_m$ is inversely proportional to the length of the polarization maintaining fiber $L_f$.

There is therefore in place a technique for measuring the current through a conductor: as a consequence of the Biot-Savart Law, an infinitely long conducting wire, for example, carrying a current i, gives rise to a magnetic field whose magnitude at a distance R from the wire is $\mu_0 i \div (2\pi R)$, where $\mu_0$ is the permeability of free space. If the Sagnac interferometer described above is immersed in this magnetic field, the properties of the polarization maintaining fiber 37 that composes the coil will change so as to affect the interference pattern observed. Thus, from the change in this pattern, the current i can be inferred. Similar current sensors are known in the prior art, e.g., *Interferometer device for measurement of magnetic fields and electric current pickup comprising a device,* United States utility patent application, filed May 14, 1985, application number 4,560,867, naming Papuchon; Michel; Arditty; Herve; Puech; Claude as inventors, which is incorporated by reference herein. The design of current sensors is similar to that of fiber optic rotation sensors of the type that appears in *Fiber Optic Rotation Sensor or Gyroscope with Improved Sensing Coil,* United States utility patent application, filed April 7, 1995, application number 5,552,887, naming Dyott, Richard B. as inventor, which is incorporated by reference herein.

The aforementioned current sensor has several attractive features. It has no moving parts, resulting in enhanced reliability. There are no cross-axis sensitivities to vibration, acceleration or shock. The current sensor is stable with respect to temperature fluctuations and has a long operational life, making it useful in a wide variety of applications, including land navigation, positioning, robotics and instrumentation.

One application of the current sensor is for the measurement of high voltages (> 0.1MV) in conductors present in voltage transformers. About six meters of polarization maintaining fiber is wound into a multi-turn loop, annealed *in situ* and then the conductor is threaded through the sensing coil. The current sensor can also be used as a trip-out device that would very quickly detect a short-circuit.

It will be understood by those of ordinary skill in the art, that perfectly linearly or circularly polarized light may be an idealization that can not be realized. I.e., in practice, there may exist uncontrollable factors that give rise to some deviations from perfectly linearly or circularly polarized light. Therefore, it should be understood that when reference is made to linearly or circularly polarized light the meaning of these terms should be taken to mean effectively or approximately linearly or circularly polarized light.

While the invention has been disclosed in connection with the preferred embodiments shown and described in detail, various modifications and improvements thereon will become readily apparent to those skilled in the art. Accordingly, the and scope of the present invention is to be limited only by the following claims.

**Claims**

1. A transformer of polarized light comprising a section of birefringent fiber (2, 4) which has a twisted section (10) extending along the longitudinal axis of the fiber, said twisted section (10) having a twist angle of approximately $\pi/4$ radians, wherein linearly polarized light entering a proximate end of the fiber (2, 4) and traversing the twisted section exits the fiber (2, 4) at its distal end as substantially circularly polarized,
**characterized in that**
the distance between the distal end of the fiber (2, 4) and the portion of the twisted section (10) facing the distal end of the fiber is approximately an odd multiple of one quarter of a beat length.

2. A method of fabricating a transformer of polarized light from a section of birefringent fiber (12) comprising:

   twisting the section along the longitudinal axis of the birefringent fiber (12) between a proximate and a distal end of the fiber by a twist angle of approximately $\pi/4$ radians; and
   heating a portion of the twisted section (14) so as to form a transition region.

   **characterized in that**
   the distance between the distal end of the fiber (12) and the portion of the twisted section (14) facing the distal end of the fiber is approximately an odd multiple of one quarter of a beat length.

3. The method of claim 2, further comprising:

   illuminating the proximate end of the fiber (12) with substantially linearly polarized light;
   monitoring the polarization of the light exiting the distal end of the fiber (12); and if the light exiting the fiber (12) is not substantially circularly polarized, continuing heating the portion of the twisted section (14) so as to fine-tune the twist angle and/or the distance between the distal end of the fiber and the portion of the twisted section facing the distal end of the fiber, until the light exiting the fiber is substantially circularly polarized.

4. A current sensor comprising

   a) a source of linearly polarized light (32);
   b) a transformer of polarized light (35) for transforming the linearly polarized light to circularly polarized light, said transformer including a section of birefringent fiber (2, 4; 12) which has a twisted section (10; 14) extending along the longitudinal axis of the fiber, said twisted section (10; 14) having a twist angle of approximately $\pi/4$ radians, wherein linearly polarized light entering a proximate end of the fiber and traversing the twisted section exits the fiber at its distal end substantially circularly polarized;
   c) a coil (41) of a not biretringent, polarization maintaining optical fiber (37) having at least one turn and surrounding an electrical conductor (38) carrying an electric current;
   d) a directional coupler (36) which optically couples the circularly polarized light from the transformer of polarized light (35) to the coil (41) to create counter-propagating light beams within the coil; and
   e) an optical detector (34) for receiving said counter-propagated light beams for producing an output signal indicative of a magnetic field produced by the electric current,

   **characterized in that**
   the distance between the distal end of the fiber (2, 4; 12) and the portion of the twisted section (10; 14) facing the distal end of the fiber is approximately an odd multiple of one quarter of a beat length.

5. A method of detecting the current in a conductor comprising:

   a) providing a source of linearly polarized light (32);

   b) transforming the linearly polarized light into circularly polarized light using a transformer of polarized light (35), said transformer including a section of birefringent fiber (2, 4; 12) which has a twisted section (10; 14) extending along the longitudinal axis of the fiber, said twisted section (10; 14) having a twist angle of approximately π/4 radians, wherein linearly polarized light entering a proximate end of the fiber and traversing the twisted section exits the fiber at its distal end substantially circularly polarized,

c) providing a coil (41) of a not birefringent, polarization maintaining optical fiber (37) having at least one turn and surrounding an electrical conductor (38) carrying an electric current;

d) with a directional coupler (36), coupling the circularly polarized light from the transformer of polarized light (35) to the coil (41) to create counter-propagating light beams within the coil; and

e) receiving said counter-propagating light beams with an optical detector (34) for producing an output signal indicative of a magnetic field produced by the electric current,

**characterized in that**
the distance between the distal end of the fiber (2, 4; 12) and the portion of the twisted section (10; 14) facing the distal end of the fiber is approximately an odd multiple of one quarter of a beat length.

**Patentansprüche**

1. Wandler für polarisiertes Licht, umfassend einen Abschnitt einer doppelbrechenden Faser (2, 4), welche einen gewundenen bzw. verdrillten Abschnitt (10) aufweist, welcher sich entlang der Längsachse der Faser erstreckt, wobei der verdrillte Abschnitt (10) einen Verdrillwinkel von etwa π/4 rad aufweist, worin linear polarisiertes Licht, welches in ein benachbartes bzw. anliegendes Ende der Faser (2, 4) eintritt und den verdrillten Abschnitt durchquert, die Faser (2, 4) an ihrem distalen Ende als im wesentlichen zirkular bzw. kreispolarisiert verläßt,
**dadurch gekennzeichnet, daß**
der Abstand zwischen dem distalen Ende der Faser (2, 4) und dem Abschnitt des verdrillten Bereichs (10), welcher zu dem distalen Ende der Faser gerichtet ist, ungefähr ein ungerades Vielfaches eines Viertels einer Schwebungslänge ist.

2. Verfahren zur Herstellung eines Wandlers von polarisiertem Licht aus einem Abschnitt bzw. Bereich einer doppelbrechenden Faser (12), umfassend:

Verdrehen bzw. Verdrillen des Abschnitts bzw. Bereichs entlang der Längsachse der doppelbrechenden Faser (12) zwischen einem proximalen bzw. benachbarten und einem distalen Ende der Faser um einen Verdrillwinkel von etwa π/4 rad; und
Erwärmen eines Abschnitts des verdrillten Bereichs (14), um einen Übergangsbereich bzw. eine Übergangsregion auszubilden,

**dadurch gekennzeichnet, daß**
der Abstand zwischen dem distalen Ende der Faser (12) und dem Abschnitt des verdrillten Bereichs (14), welcher zu dem distalen Ende der Faser gerichtet ist, ungefähr ein ungerades Vielfaches eines Viertels einer Schwebungslänge ist.

3. Verfahren nach Anspruch 2, weiters umfassend:

Beleuchten des proximalen Endes der Faser (12) mit im wesentlichen linear polarisiertem Licht;
Überwachen der Polarisierung des Lichts, welches das distale Ende der Faser (12) verläßt; und
wenn das Licht, welches die Faser (12) verläßt, nicht im wesentlichen zirkular polarisiert ist, Fortsetzen eines Erwärmens des Abschnitts des verdrillten Bereichs (14), um den Verdrillwinkel und/oder den Abstand zwischen dem distalen Ende der Faser und dem Abschnitt des verdrillten Bereichs, welcher zum distalen Ende der Faser gerichtet ist, fein einzustellen, bis das Licht, welches die Faser verläßt, im wesentlichen zirkular polarisiert ist.

4. Stromsensor, umfassend:

a) eine Quelle eines linear polarisierten Lichts (32);
b) einen Wandler von polarisiertem Licht (35) zum Wandeln bzw. Transformieren des linear polarisierten Lichts in zirkular polarisiertes Licht, wobei der Wandler einen Bereich einer doppelbrechenden Faser (2, 4; 12) aufweist, welche einen gewundenen bzw. verdrillten Abschnitt (10; 14) aufweist, welcher sich entlang der Längsachse der Faser erstreckt, wobei der verdrillte Abschnitt (10; 14) einen Verdrillwinkel von etwa π/4 rad aufweist, worin linear polarisiertes Licht, welches in ein benachbartes bzw. proximates Ende der Faser eintritt und den verdrillten Abschnitt durchquert, die Faser an ihrem distalen Ende als im wesentlichen zirkular bzw. kreispolarisiert verläßt,

c) eine Spule (41) einer nicht doppelbrechenden, eine Polarisation aufrechterhaltenden, optischen Faser (37), welche wenigstens eine Windung bzw. Dehnung aufweist und einen elektrischen Leiter (38) umgibt, welcher einen elektrischen Strom führt;

d) einen Richtungskoppler (36), welcher optisch das zirkular polarisierte Licht von dem Wandler für polarisiertes Licht (35) zu der Spule (41) koppelt, um in Gegenrichtung fortschreitende Lichtstrahlen innerhalb der Spule zu erzeugen; und

e) einen optischen Detektor (34) zum Empfangen der in Gegenrichtung fortschreitenden Lichtstrahlen zum Erzeugen eines Ausgabe- bzw. Ausgangssignals, welches für ein Magnetfeld anzeigend ist, welches durch den elektrischen Strom erzeugt wird,

**dadurch gekennzeichnet, daß**
der Abstand zwischen dem distalen Ende der Faser (2, 4; 12) und der Abschnitt des verdrillten Bereichs (10; 14), welcher zu dem distalen Ende der Faser gerichtet ist, ungefähr ein ungerades Vielfaches eines Viertels einer Schwebungslänge ist.

5. Verfahren zum Detektieren des Stroms in einem Leiter, umfassend:

a) Bereitstellen einer Quelle für linear polarisiertes Licht (32);

b) Transformieren des linear polarisierten Lichts in zirkular polarisiertes Licht unter Verwendung eines Wandlers (35) für polarisiertes Licht, wobei der Wandler einen Bereich einer doppelbrechenden Faser (2, 4; 12) aufweist, welche einen gewundenen bzw. verdrillten Abschnitt (10; 14) aufweist, welcher sich entlang der Längsachse der Faser erstreckt, wobei der verdrillte Abschnitt (10; 14) einen Verdrillwinkel von etwa π/4 rad aufweist, worin linear polarisiertes Licht, welches in ein benachbartes bzw. proximales Ende der Faser eintritt und den verdrillten Abschnitt durchquert, die Faser an ihrem distalen Ende als im wesentlichen zirkular bzw. kreispolarisiert verläßt,

c) Bereitstellen einer Spule (41) einer nicht doppelbrechenden, eine Polarisation aufrechterhaltenden, optischen Faser (37), welche wenigstens eine Windung bzw. Dehnung aufweist und einen elektrischen Leiter (38) umgibt, welcher einen elektrischen Strom führt;

d) mit einem Richtungskoppler (36), welcher das zirkular polarisierte Licht von dem Wandler für polarisiertes Licht (35) zu der Spule (41) koppelt, um in Gegenrichtung fortschreitende Lichtstrahlen innerhalb der Spule zu erzeugen; und

e) Empfangen der in Gegenrichtung fortschreitenden Lichtstrahlen mit einem optischen Detektor (34) zum Erzeugen eines Ausgangssignals, welches für ein Magnetfeld anzeigend ist, welches durch den elektrischen Strom erzeugt wird;

**dadurch gekennzeichnet, daß**
der Abstand zwischen dem distalen Ende der Faser (2, 4; 12) und dem Abschnitt des verdrillten Bereichs (10; 14), welcher zu dem distalen Ende der Faser gerichtet ist, ungefähr ein ungerades Vielfaches eines Viertels einer Schwebungslänge ist.

## Revendications

1. Transformateur de lumière polarisée comprenant une section de fibre biréfringente (2, 4) ayant une section torsadée (10) s'étendant le long de l'axe longitudinal de la fibre, ladite section torsadée (10) ayant un angle de torsion de π/4 radians approximativement, dans laquelle la lumière polarisée linéairement entrant par une extrémité proximale de la fibre (2, 4) et traversant la section torsadée sort de la fibre (2, 4) à son extrémité distale en étant pour l'essentiel polarisée circulairement,
**caractérisé en ce que**
la distance entre l'extrémité distale de la fibre (2, 4) et la portion de la section torsadée (10) faisant face à l'extrémité distale de la fibre est environ égale à un multiple impair d'un quart de longueur de battement.

2. Procédé de fabrication d'un transformateur de lumière polarisée à partir d'une section de fibre biréfringente (12) comprenant :

le torsadage de la section le long de l'axe longitudinal de la fibre biréfringente (12) entre une extrémité proximale et une extrémité distale de la fibre selon un angle de torsion d'environ $\pi/4$ radians ; et
le chauffage d'une portion de la section torsadée (14) de façon à former une région de transition,

**caractérisé en ce que**
la distance entre l'extrémité distale de la fibre (12) et la portion de la section torsadée (14) faisant face à l'extrémité distale de la fibre est environ égale à un multiple impair d'un quart de longueur de battement.

3. Procédé selon la revendication 2, comprenant en outre :

l'éclairement de l'extrémité proximale de la fibre (12) par une lumière polarisée pour l'essentiel linéairement ;
le contrôle de la polarisation de la lumière sortant par l'extrémité distale de la fibre (12) ; et si la lumière sortant de la fibre (12) n'est pas pour l'essentiel polarisée circulairement, la poursuite du chauffage de la portion de la section torsadée (14) de façon à ajuster finement l'angle de torsion et/ou la distance entre l'extrémité distale de la fibre et la portion de la section torsadée faisant face à l'extrémité distale de la fibre, jusqu'à ce que la lumière quittant la fibre soit pour l'essentiel polarisée circulairement.

4. Capteur de courant comprenant

a) une source de lumière polarisée linéairement (32) ;
b) un transformateur de lumière polarisée (35) pour transformer la lumière polarisée linéairement en une lumière polarisée circulairement, ledit transformateur incluant une section de fibre biréfringente (2, 4, 12) qui a une section torsadée (10, 14) s'étendant le long de l'axe longitudinal de la fibre, ladite section torsadée (10, 14) ayant un angle de torsion d'environ $\pi/4$ radians, dans laquelle la lumière polarisée linéairement pénétrant par une extrémité proximale de la fibre et traversant la section torsadée sort de la fibre par son extrémité distale en étant pour l'essentiel polarisée circulairement ;
c) une bobine (41) de fibre optique non biréfringente à maintien de polarisation (37) comportant au moins un tour et entourant un conducteur électrique (38) transportant un courant électrique ;
d) un coupleur directionnel (36) qui couple optiquement la lumière polarisée circulairement depuis le transformateur de lumière polarisée (35) vers la bobine (41) pour créer des faisceaux de lumière se propageant à contre dans la bobine ; etc.
e) un détecteur optique (34) pour recevoir lesdits faisceaux lumineux se propageant à contre pour produire un signal de sortie indicatif d'un champ magnétique produit par le courant électrique,

**caractérisé en ce que**
la distance entre l'extrémité distale de la fibre (2, 4, 12) et la portion de la section torsadée (10, 14) faisant face à l'extrémité distale de la fibre est environ égale à un multiple impair d'un quart de longueur de battement.

5. Procédé de détection du courant dans un conducteur, comprenant :

a) la fourniture d'une source de lumière polarisée linéairement (32) ;
b) la transformation de la lumière linéairement polarisée en une lumière polarisée circulairement à l'aide d'un transformateur de lumière polarisée (35), ledit transformateur incluant une section de fibre biréfringente (2, 4, 12) qui a une section torsadée (10, 14) s'étendant le long d'un axe longitudinal de la fibre, ladite section torsadée (10, 14) ayant un angle de torsion d'environ $\pi/4$ radians, dans laquelle la lumière linéairement polarisée entrant par une extrémité proximale de la fibre et traversant la section torsadée sort de la fibre à son extrémité distale en étant pour l'essentiel circulairement polarisée ;
c) la fourniture d'une bobine (41) de fibre optique non biréfringente (37) à maintien de polarisation, comportant au moins un tour et entourant un conducteur électrique (38) transportant un courant électrique ;
d) à l'aide d'un coupleur directionnel (36), le couplage la lumière polarisée circulairement provenant du transformateur de lumière polarisée (35) à la bobine (41) pour créer des faisceaux lumineux se propageant à contre dans la bobine ; et
e) la réception desdits faisceaux lumineux se propageant à contre dans un détecteur optique (34) pour la production d'un signal de sortie indicatif d'un champ magnétique produit par le courant électrique,

**caractérisé en ce que**

la distance entre l'extrémité distale de la fibre (2, 4, 12) et la portion de la section torsadée (10, 14) faisant face à l'extrémité distale de la fibre est égale à environ un multiple impair d'un quart de longueur de battement.

$$\text{Fig. 1}$$

Fig. 2

Fig. 3

fig. 4

EP 1 151 309 B1